(19) Europäisches Patentamt
European Patent Office
Office européen des brevets

(11) **EP 1 845 383 B1**

(12) **FASCICULE DE BREVET EUROPEEN**

(45) Date de publication et mention de la délivrance du brevet:
**16.03.2011   Bulletin 2011/11**

(51) Int Cl.:
***G01R 15/18*** *(2006.01)*   ***H02H 1/04*** *(2006.01)*

(21) Numéro de dépôt: **07105207.0**

(22) Date de dépôt: **29.03.2007**

(54) **Procédé de détection de saturation d'un transformateur de courant**

Verfahren zur Erkennung der Sättigung eines Stromtransformators

Method of detecting saturation of a current transformer

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité:  **04.04.2006  FR 0651179**

(43) Date de publication de la demande:
**17.10.2007   Bulletin 2007/42**

(73) Titulaire: **Areva T&D Protection & Controle 34970 Lattes (FR)**

(72) Inventeurs:
• **Casadoumecq, Christophe**
  **34090, Montpellier (FR)**
• **Montaner, Patrick**
  **30920 Codognan (FR)**

(74) Mandataire: **Augarde, Eric et al**
**BREVALEX**
**95 rue d'Amsterdam**
**75378 Paris Cedex 8 (FR)**

(56) Documents cités:
EP-A- 0 882 990    WO-A-2004/093115
FR-A- 2 835 319    US-A1- 2005 094 344

**Description**

**DOMAINE TECHNIQUE**

La présente invention concerne le domaine de la détection de saturation dans un transformateur de courant, en particulier pour une application à la protection d'un jeu de barres.

**ÉTAT DE LA TECHNIQUE ANTÉRIEURE**

Les transformateurs de courant jouent un rôle essentiel dans la protection des réseaux haute tension. En effet les relais assurant l'isolation de l'élément du réseau à protéger ne pouvant être montés directement sur le réseau, on utilise des transformateurs de courant permettant d'estimer indirectement l'intensité de courant dans l'élément en question. Si l'intensité primaire est élevée on utilise des transformateurs de courant à conducteur traversant, c'est-à-dire à primaire non bobiné. On connaît plusieurs types de protection à l'aide de transformateurs de courant. Selon un premier type de protection dite à maximum d'intensité, le courant mesuré au secondaire du transformateur de courant (TC) est comparé à une valeur maximale autorisée, le dépassement de cette valeur déconnectant de l'alimentation HT l'élément en question au moyen d'un relais. Selon un second type de protection visant à se prémunir contre les défauts entre phase et neutre et pour cette raison dite homopolaire, des transformateurs de courant sont montés respectivement sur les trois conducteurs de phase alimentant l'élément à protéger. Les courants apparaissant au secondaire de ces transformateurs sont sommés et des relais de protection sont activés lorsque la somme dépasse une valeur de seuil prédéterminée. Selon un troisième type de protection, dite différentielle, la différence entre les courants entrant et sortant de l'élément à protéger est estimée au moyen de transformateurs de courant montés en amont et aval dudit élément. Si ladite différence excède une valeur de seuil prédéterminée, le relais de protection est activé.

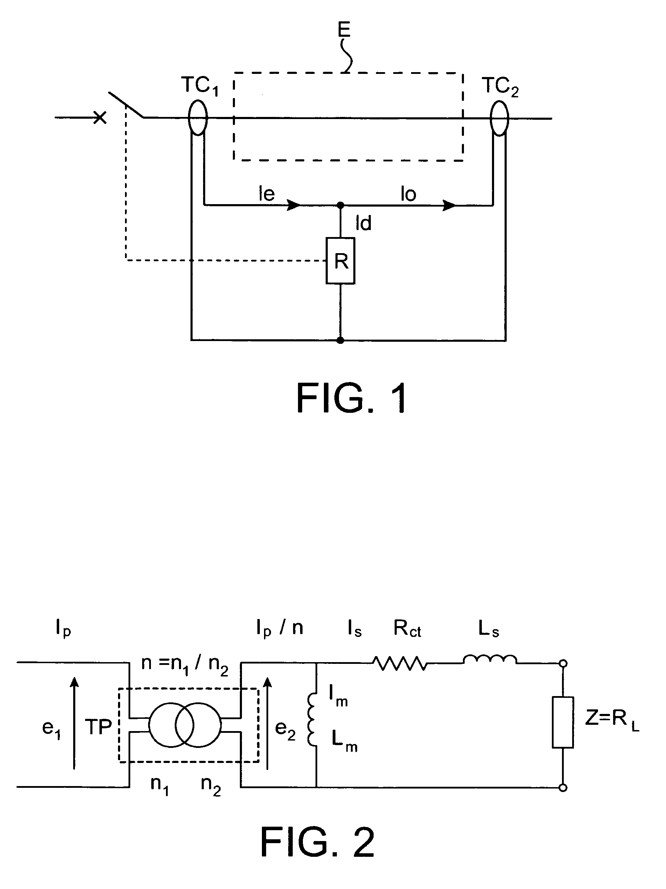

La Fig. 1 représente schématiquement un exemple de protection différentielle d'un élément E d'un réseau HT. Des transformateurs de courant $TC_1$ et $TC_2$ sont prévus en amont et en aval de cet élément. Le courant Id, différence entre les courants Ie et Io apparaissant respectivement au secondaire de $TC_1$ et $TC_2$, traverse le relais R. Moyennant des caractéristiques identiques des transformateurs $TC_1$ et $TC_2$ et un fonctionnement hors saturation, le courant Id est proportionnel à la différence des courants entrant et sortant de l'élément E. Lorsque le courant Id excède le courant Ir de réglage du relais, c'est-à-dire en cas de défaut interne de l'élément, le relais est activé et l'élément est isolé du réseau.

Quel que soit le type de protection envisagé, celle-ci n'est efficace que si les transformateurs de courant fournissent une mesure correcte des courants au primaire. Ceci impose notamment que les transformateurs ne soient pas saturés. Comme on le verra plus loin, une saturation du transformateur intervient pour des valeurs élevées de champ magnétique $\vec{H}$ ou, de manière équivalente, pour des valeurs de flux magnétique élevées. Pour des raisons tant pratiques qu'économiques, il n'est pas possible d'utiliser des transformateurs de courant dont on puisse garantir l'absence de saturation dans toute la plage de mesure. On est donc conduit à utiliser des transformateurs de courant saturables.

La Fig. 2 montre le schéma électrique d'un transformateur de courant saturable. On a représenté par TP un transformateur de courant parfait de rapport de transformation n, débitant par conséquent au secondaire un courant $I_s=I_p/n$ où $I_p$ est le courant primaire. En outre, $L_m$ indique l'inductance magnétique, $I_m$ le courant d'excitation qui la traverse, $I_s$ le courant réel mesuré au secondaire, $R_{ct}$ la résistance du secondaire, $L_s$ l'inductance de fuite du secondaire généralement négligeable et Z l'impédance de la charge aux bornes du secondaire. Dans la suite on supposera l'impédance de charge Z purement résistive : $2=R_L$.

Dans les conditions normales de fonctionnement, c'est-à-dire hors saturation, le courant d'excitation $I_m$ est faible et le courant mesuré $I_s$ est sensiblement proportionnel au courant primaire $I_p$. En revanche, si le transformateur de courant sature, c'est-à-dire si le flux magnétique atteint sa valeur maximale, l'inductance magnétique $L_m$ décroît alors brusquement, ce qui entraîne une augmentation du courant d'excitation $I_m$. On voit ainsi que, dans ce cas, le courant mesuré $I_s$ n'est plus une représentation fidèle du courant primaire $I_p$.

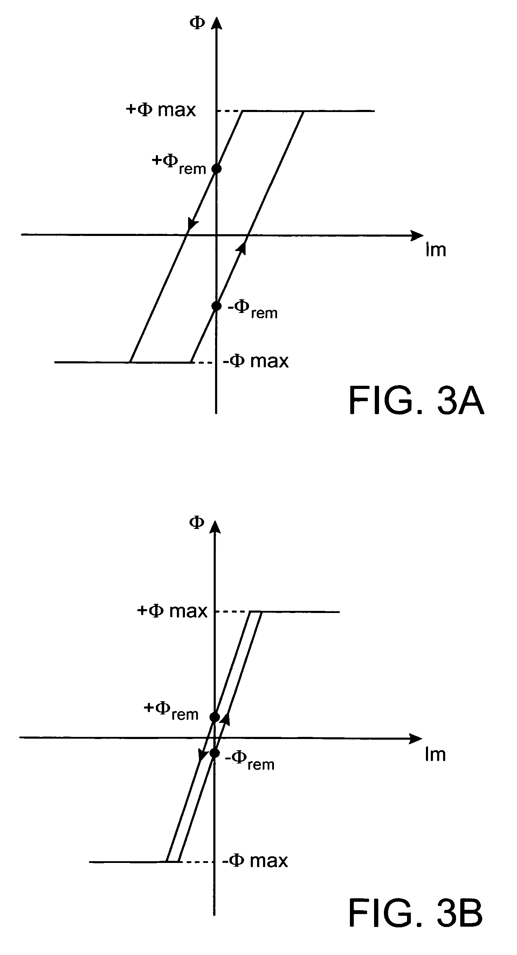

Les Figs. 3A et 3B représentent les caractéristiques respectives de deux types de transformateurs de courant. Il convient de rappeler préalablement que les transformateurs de courant sont classés et caractérisés par les normes NF C 42-502 et CEI 185. On peut distinguer deux grandes classes de transformateurs selon qu'ils sont utilisés pour la simple mesure de courant ou pour la protection. Ces deux classes correspondent à des marges d'erreur de mesure

$$\frac{\left| I_p/n - Is \right|}{I_p/n}$$ différentes.

La Fig. 3A représente la caractéristique d'un transformateur de courant appartenant à la classe TPX ou X (sans entrefer). On a fait figurer en abscisse le courant d'excitation $I_m$ et le flux magnétique Φ en ordonnée. Etant donné que le flux magnétique est proportionnel à l'amplitude du vecteur induction $\vec{B}$ et que le courant d'excitation est proportionnel à l'amplitude du champ magnétique $\vec{H}$, cette caractéristique est similaire à la courbe de magnétisation B=f(H).

**EP 1 845 383 B1**

La caractéristique présente à la fois une hystérésis et une saturation pour des courants d'excitation élevés. Sur la figure, $\pm \Phi_{max}$ et $\pm \Phi_{rem}$ désignent respectivement la valeur du flux magnétique à la saturation et la valeur du flux rémanent, la saturation pouvant bien entendu intervenir tant pour des valeurs positives que négatives du flux. Pour les transformateurs de courant appartenant à la classe TPX, le flux magnétique rémanent n'excède pas 80% du flux magnétique à la saturation, autrement dit $\Phi_{rem} \leq 0.8\Phi_{max}$.

La Fig. 3B représente la caractéristique d'un transformateur de courant appartenant à la classe dite TPY (avec entrefer). Cette classe correspond à une marge d'erreur de mesure plus faible que dans le cas précédent. Les notations sont les mêmes qu'en Fig. 3A. Pour les transformateurs de courant appartenant à cette classe, le flux magnétique rémanent n'excède pas 20% du flux magnétique à la saturation, autrement dit $\Phi_{rem} \leq 0.2\Phi_{max}$.

Dans les deux cas représentés, on remarque une chute brutale de l'inductance magnétique $L_m$ dans la zone de saturation du transformateur.

Le flux magnétique dans le transformateur est mesuré classiquement en intégrant le courant secondaire $I_s$ dans le temps et en multipliant le résultat obtenu par la valeur de la résistance de charge $R_S$. Toutefois la caractéristique de $\Phi$ ne passant pas par l'origine, cette estimation du flux est biaisée par le flux rémanent $\Phi_{rem}$, flux dont on ne connaît pas la valeur mais simplement les bornes qui l'encadrent. Il n'est donc pas possible de déterminer si le transformateur est saturé par simple comparaison du flux mesuré avec le flux de saturation $\Phi_{max}$.

La détection de la saturation du transformateur s'avère néanmoins essentielle, d'une part pour inhiber une activation intempestive de la protection lors de la phase de saturation et d'autre part pour libérer cette même protection dès que le transformateur revient en régime non saturé.

La demande de brevet FR-A-2835319 décrit un procédé de détection de saturation d'un transformateur de courant, basé sur l'association de deux critères. Le premier critère est un écart de prédiction du courant secondaire à l'aide d'un modèle autorégressif d'ordre 2. Le second critère est une comparaison du flux magnétique, estimé par intégration du courant secondaire, avec un seuil positif et un seuil négatif. Une saturation est détectée si l'écart de prédiction est supérieur à un seuil d'erreur et si le flux magnétique estimé est en dehors de l'intervalle défini par lesdits seuils positif et négatif.

Le procédé de détection de saturation précité présente toutefois plusieurs inconvénients. Tout d'abord, l'intégration continue du courant secondaire entraîne une dérive importante du flux estimé et donc une probabilité de fausse alerte importante du second critère. Ensuite, le seuil d'erreur de prédiction du premier critère ne permet pas de discriminer efficacement les cas où le transformateur est non saturé mais l'amplitude du courant secondaire est relativement élevée, de ceux où le transformateur est saturé mais l'amplitude du courant secondaire est relativement faible. Il en résulte que la combinaison des deux critères peut conduire à une fausse détection, soit qu'une saturation est détectée alors que le transformateur n'est pas saturé, soit qu'une saturation réelle du transformateur reste non décelée. Cela se traduit, suivant le cas, par une inhibition injustifiée de la protection, c'est-à-dire un défaut de protection, ou par une activation injustifiée de la protection pouvant entraîner une déconnexion intempestive de l'élément du réseau HT.

De manière générale, l'objet de la présente invention est de proposer un procédé de détection de la saturation d'un transformateur de courant remédiant aux inconvénients précités et présentant un taux de fausse détection sensiblement plus faible que dans l'état de la technique. En outre, l'objet de l'invention est de détecter rapidement un début de saturation du transformateur lorsqu'elle apparaît et une fin de saturation du transformateur lorsque cette dernière disparaît.

**EXPOSÉ DE L'INVENTION**

La présente invention est définie par un procédé de détection de saturation d'un transformateur de courant comprenant :

- une étape de détection d'un défaut de la forme d'onde du courant secondaire du transformateur ;
- une estimation du flux magnétique dans le secondaire du transformateur au moyen d'une intégration du courant secondaire pendant une fenêtre temporelle partant de la détection dudit défaut ;
- une comparaison du flux magnétique ainsi estimé avec une valeur de seuil, la saturation du transformateur étant détectée sur franchissement de ladite valeur de seuil par ledit flux magnétique.

Ainsi l'estimation du flux par intégration ne présente pas de dérive et se fait seulement sur apparition d'un défaut.

Ladite valeur de seuil est avantageusement choisie égale à 20% de la valeur du flux magnétique à la saturation du transformateur.

En outre, si un second défaut de la forme d'onde du courant secondaire est détecté pendant ladite fenêtre temporelle, la borne supérieure de ladite fenêtre est réactualisée en fonction du temps d'apparition du second défaut. On prend ainsi en compte l'apparition de défauts successifs.

En revanche, une fin de saturation est détectée si un intervalle de temps de durée prédéterminée s'écoule sans qu'un défaut de forme d'onde du courant secondaire soit détecté.

Selon un mode de réalisation, la détection d'un défaut de la forme d'onde du courant secondaire comprend le calcul d'une grandeur caractéristique de la dérivée du signal et une comparaison de ladite grandeur avec une fraction prédéterminée de l'amplitude du courant secondaire, un défaut étant détecté si ladite grandeur excède en valeur absolue ladite fraction.

Ladite fraction est choisie égale à 16% pour un réseau électrique à 50 Hz et à 20% pour un réseau électrique à 60 Hz.

Selon une variante, la détection de saturation est inhibée tant que le courant secondaire du transformateur n'a pas atteint un extremum. De surcroît, la détection de saturation peut être inhibée pendant une durée prédéterminée après que le courant secondaire du transformateur soit devenu supérieur en valeur absolue à un seuil de bruit.

On évite ainsi une détection intempestive de la saturation lors de la mise en service du système.

L'invention concerne aussi un programme d'ordinateur comprenant des moyens logiciels adaptés à mettre en oeuvre les étapes du procédé ci-dessus, lorsqu'il est exécuté sur un ordinateur.

## BRÈVE DESCRIPTION DES DESSINS

La Fig. 1 représente schématiquement un exemple de protection différentielle à l'aide de transformateurs de courant, connu de l'état de la technique ;

La Fig. 2 représente le schéma électrique équivalent d'un transformateur de courant réel ;

Les Figs. 3A et 3B représentent les caractéristiques de deux types de transformateur de courant connus de l'état de la technique ;

La Fig. 4 représente un organigramme du procédé de détection de saturation selon un mode de réalisation de l'invention ;

La Fig. 5 illustre un exemple de forme d'onde du courant secondaire en absence et en présence de saturation ;

La Fig. 6 montre les chronogrammes de différentes variables illustrant le procédé de détection de saturation ;

La Fig. 7 illustre un système de protection d'un jeu de barres à l'aide de transformateurs de courant utilisant le procédé de détection de saturation selon l'invention.

## EXPOSÉ DÉTAILLÉ DE MODES DE RÉALISATION PARTICULIERS

L'idée à la base de l'invention est de n'effectuer une mesure du flux magnétique que de manière ponctuelle, sur apparition d'un défaut dans la forme d'onde du courant (ou de la tension) au secondaire du transformateur. La mesure se fait de manière classique par intégration de la différence de potentiel aux bornes du bobinage. Selon l'invention, l'intégration est effectuée au sein d'une fenêtre temporelle de durée finie de sorte que l'estimation du flux magnétique ne puisse dériver indéfiniment.

Le flux magnétique est mesuré par intégration dans une fenêtre temporelle $[t_d, t_d+T]$ de largeur $T$ où $t_d$ est l'instant d'apparition du défaut dans la forme d'onde, et peut s'écrire, en adoptant les notations de la Fig. 2 et en supposant que le flux est nul au temps $t_d$.

$$\Phi_{meas}(t) = -R \int_{td}^{t} i_s(\tau)\,d\tau \tag{1}$$

avec $t \in [t_d, t_d + T]$; $R = R_{CT} + R_L$ où $R_{CT}$ est la résistance interne du secondaire du transformateur et $R_L$ est la résistance de charge (appelée aussi résistance de boucle).

En pratique, le courant est échantillonné et la somme (1) est approximée par la méthode des trapèzes :

$$\Phi_{meas} = -R \sum_{k} \left(i_s(k) + i_s(k-1)\right) T_e / 2 \tag{2}$$

où $T_e$ est la période d'échantillonnage.

Le flux magnétique réel $\Phi_r$ dans le secondaire du transformateur s'exprime quant à lui par :

$$\Phi_r(t) = -\int_{t_0}^{t} e_2(\tau)d\tau = L_m I_m(t) \qquad (3)$$

où $t_0$ est un instant d'initialisation où le flux est nul. Le flux magnétique réel diffère du flux mesuré par la valeur du flux rémanent $\Phi_{rem}$, qui peut être considéré comme la composante continue du flux réel :

$$\Phi_r = \Phi_{meas} + \Phi_{rem} \qquad (4)$$

Comme on l'a vu plus haut la composante de flux rémanent ne peut être déterminée simplement. Afin de détecter si le transformateur est saturé, le procédé selon l'invention effectue la comparaison :

$$\left|\Phi_{meas}\right| \geq \Phi_T \qquad (5)$$

où $\Phi_T$ est une valeur de seuil convenablement choisie. De manière avantageuse on prendra $\Phi_T = 0.2\Phi_{max}$ quelle que soit la classe du transformateur de courant utilisé. En effet, en se plaçant dans le pire cas (Fig. 3A) le flux rémanent peut atteindre au plus la valeur $\Phi_{rem} = 0.8\Phi_{max}$. Dès lors, un flux réel supérieur à $\Phi_{max}$ se traduira nécessairement par un flux mesuré supérieur à $0.2\Phi_{max}$. La saturation du transformateur sera par conséquent détectée au moyen de la comparaison (5) quelle que soit la classe du transformateur.

La valeur de saturation $\Phi_{max}$ peut être estimée en fonction de l'expression suivante :

$$\Phi_{max} = \frac{V_k I_N}{\pi F T_e} \qquad (6)$$

où $V_k$ est la tension de coude de la courbe d'excitation $e_2 = f(I_m)$ avec les notations de la Fig.2, $I_N$ est le courant nominal du secondaire du transformateur et F est la fréquence du réseau. On rappelle que la tension de coude est définie comme la tension aux bornes du secondaire à partir de laquelle une augmentation de 50% du courant d'excitation ($I_m$) ne génère plus qu'une augmentation de cette tension. Les paramètres $V_k$, $I_N$ du transformateur sont données par le constructeur.

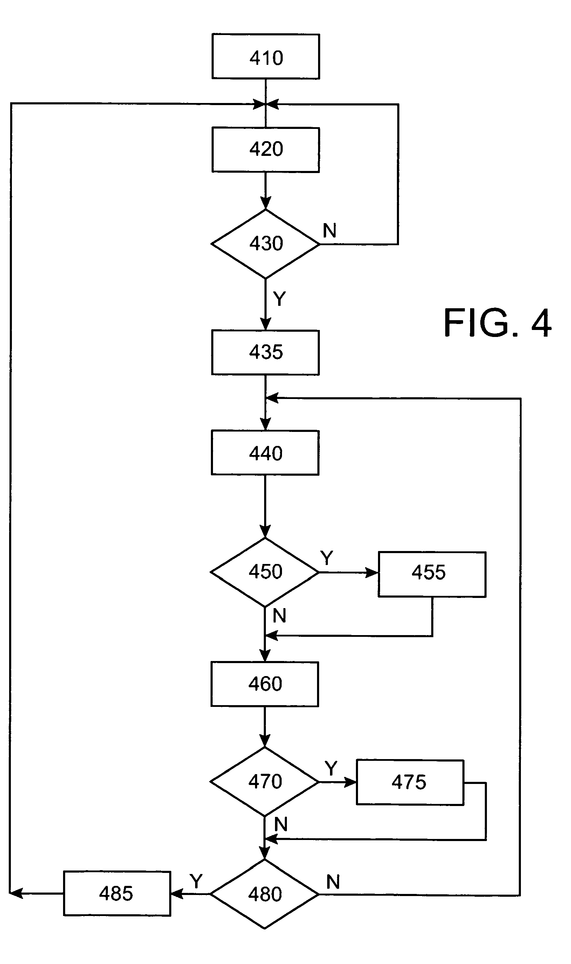

La Fig. 4 représente un organigramme simplifié du procédé de détection de saturation. L'algorithme est initialisé en 410. L'étape d'initialisation 410 comporte tout d'abord l'acquisition des paramètres du transformateur à savoir $I_N$, $V_k$, $R_{CT}$, de la résistance de charge $R_L$, des fréquences réseau F et échantillonnage $F_e$. Au départ, le courant est nul, le flux est initialisé à zéro, $\Phi_{meas}(0)=0$ et le drapeau de saturation est mis à zéro (flag_sat=0).

A l'étape 420, on mesure le courant (ou la tension) au secondaire du transformateur et l'on applique un critère estimant la déformation de la forme d'onde du signal mesuré, comme il sera détaillé plus loin.

A l'étape 430, on détecte si un défaut est présent, c'est-à-dire si la forme d'onde présente un défaut au sens de ce critère. Dans la négative, le procédé reboucle sur l'étape 420. Dans l'affirmative, si un défaut survient à un temps $t_{d0}$ le procédé se poursuit par l'ouverture en 435 d'une fenêtre temporelle d'intégration de largeur $T^{(0)}$, c'est-à-dire la détermination d'une borne temporelle supérieure d'intégration $t_{d0} + T^{(0)}$. L'étape d'intégration 440 correspond à une itération de calcul de l'expression (2) à savoir :

$$\Phi_{meas}(k) = \Phi_{meas}(k-1) - R(i_s(k) + i_s(k-1))T_e/2 \qquad (7)$$

A l'étape 450, on compare si le flux mesuré par intégration est supérieur à la valeur de seuil $\Phi_T$. Dans l'affirmative, une saturation est signalée à l'étape 455 en levant le drapeau de saturation (flag_sat=1).

Quel que soit le résultat de la comparaison, on passe ensuite à l'étape 460. On applique à nouveau le critère estimant la déformation de la forme d'onde du courant. On teste en 470 si un nouveau défaut est apparu et dans la négative on passe au test suivant 480. Si un second défaut est détecté en 470 à un instant $t_{d1}$ (à l'intérieur de la fenêtre $[t_{d0}, t_{d0}+T^{(0)}]$), on calcule la somme $t_{d1} + T^{(1)}$ où $T^{(1)}$ est la durée d'une seconde fenêtre d'intégration et si $t_{d1} + T^{(1)} > t_{d0} + T^{(0)}$ la fenêtre d'intégration initiale est prolongée jusqu'à $t_{d1} + T^{(1)}$ à l'étape 475. A chaque fois qu'un nouveau défaut survient, la fenêtre d'intégration est actualisée, c'est-à-dire éventuellement prolongée comme indiquée plus haut. Avantageusement, la suite $T^{(0)}$, $T^{(1)}$, .. , $T^{(n)}$ est choisie décroissante. Par exemple $T^{(0)}$=100 ms et $T^{(1)}$=...=$T^{(n)}$=50 ms.

En 480, on teste si l'on atteint la borne supérieure d'intégration. Si c'est le cas, on abaisse le drapeau de saturation (*flag_sat*=0) en 485 et l'on revient en 420 à la boucle de surveillance de défaut. Si la borne d'intégration n'est pas atteinte, le procédé se poursuit par une nouvelle itération d'intégration en 440. On notera qu'une fin de saturation est détectée si un intervalle de temps de durée $T^{(n)}$ s'est écoulé sans qu'un défaut de forme d'onde du courant secondaire ait été détecté.

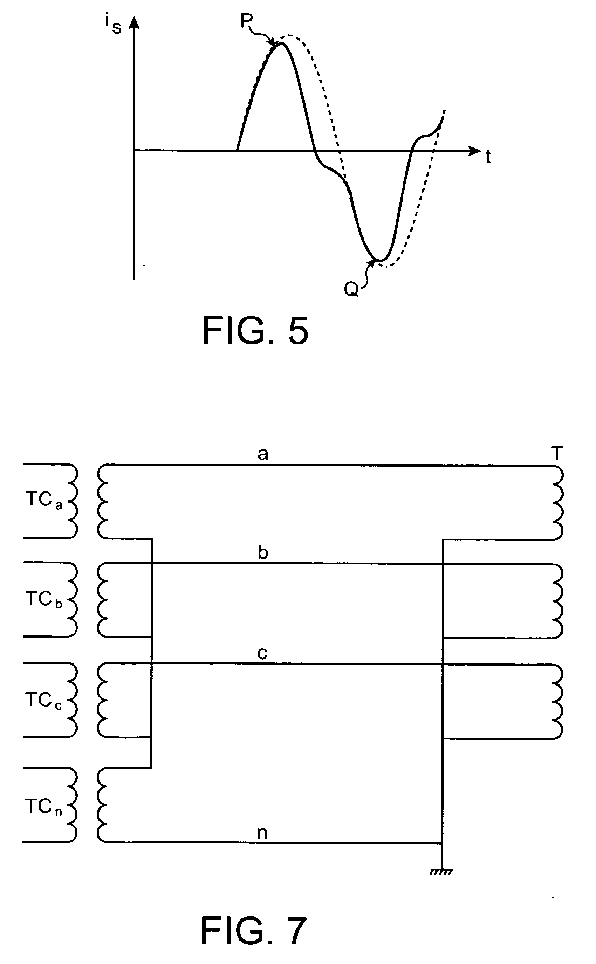

Le critère de défaut ou de déformation de la forme d'onde mis en oeuvre aux étapes 420 et 460 est avantageusement fondé sur l'estimation de la dérivée du signal mesuré. Plus précisément, on a représenté en Fig. 5 la forme d'onde du courant secondaire en absence (courbe en trait interrompu) et en présence (courbe en trait plein) de saturation du transformateur. En absence de saturation, la forme d'onde est sensiblement sinusoïdale et les échantillons de courant s'expriment sous la forme :

$$i_s(k) = A \sin\left(2\pi k / M + \varphi\right) \qquad (8)$$

où M est le rapport en la fréquence d'échantillonnage et la fréquence du courant, A son amplitude, $\varphi$ son déphasage et k le numéro de l'échantillon.

La dérivée peut être estimée sous forme d'un accroissement normalisé :

$$\frac{\Delta i_s(k)}{A} = \frac{i_s(k+1) - i_s(k)}{A} = 2\sin\left(\pi / M\right).\cos(\pi(2k+1)/M + \varphi) \qquad (9)$$

Cette expression est bornée en valeur absolue par la grandeur $G = 2|\sin(\pi/M)|$ qui ne dépend que du rapport de la fréquence d'échantillonnage à la fréquence du courant. Ainsi, pour une fréquence d'échantillonnage de 2400 Hz, et une fréquence du réseau F=50 Hz, on a G=0.16. Pour une fréquence du réseau F=60 Hz, on a G=0.19.

On peut alors choisir comme critère de déformation de la forme d'onde l'expression $\dfrac{\left|\Delta i_s(k)\right|}{A}$. Si cette expression possède une valeur supérieure à G, un défaut est détecté.

Sur la Fig. 5, une saturation apparaît au point P, entraînant une décroissance plus rapide de la forme d'onde que dans le cas non saturé. De même une saturation apparaît au point Q, entraînant une croissance plus rapide de la forme d'onde que dans le cas non saturé.

Le critère fondé sur le rapport $\dfrac{\left|\Delta i_s(k)\right|}{A}$ présente l'avantage d'être robuste et facile à mettre en oeuvre. En règle générale, l'amplitude A de la forme d'onde peut varier dans le temps et on l'estime comme le maximum de $i_s(k)$ pris sur la dernière période. Afin de ne pas obtenir des dépassements de calcul, on borne l'amplitude estimée de manière à ce qu'elle soit toujours supérieure à la moitié du courant nominal $I_{N^*}$ du transformateur.

Selon un autre mode de réalisation, la déformation de la forme d'onde est détectée au moyen d'un filtrage numérique à une fréquence harmonique du réseau, par exemple 2F. Si le rapport de la puissance de l'harmonique à la puissance du fondamental est supérieur à un certain seuil, un défaut est détecté.

Selon une variante de réalisation de l'invention, le signal de saturation en 455 est inhibé tant que le courant secondaire augmente sur trois échantillons successifs à savoir :

$$\left|i_s(k-2)\right| < \left|i_s(k-1)\right| < \left|i_s(k)\right| \qquad (10)$$

Autrement dit, tant qu'un extremum de la fonction d'onde n'est pas atteint, il ne peut y avoir saturation. La condition supplémentaire (10) permet d'éviter une détection de saturation intempestive lors de la mise en service du système.

Selon une variante spécifique de réalisation, une sécurité supplémentaire peut être ajoutée. Celle-ci prévoit que le signal de saturation en 455 sera encore inhibé si la saturation intervient moins d'un temps de garde après la détection d'un courant secondaire non nul, c'est-à-dire en pratique après que le courant secondaire soit devenu supérieur, en valeur absolue, à un seuil de bruit. Ce temps de garde est avantageusement choisi inférieur à la somme du temps minimum nécessaire pour déceler un défaut et du temps minimum de saturation du transformateur garanti par le constructeur.

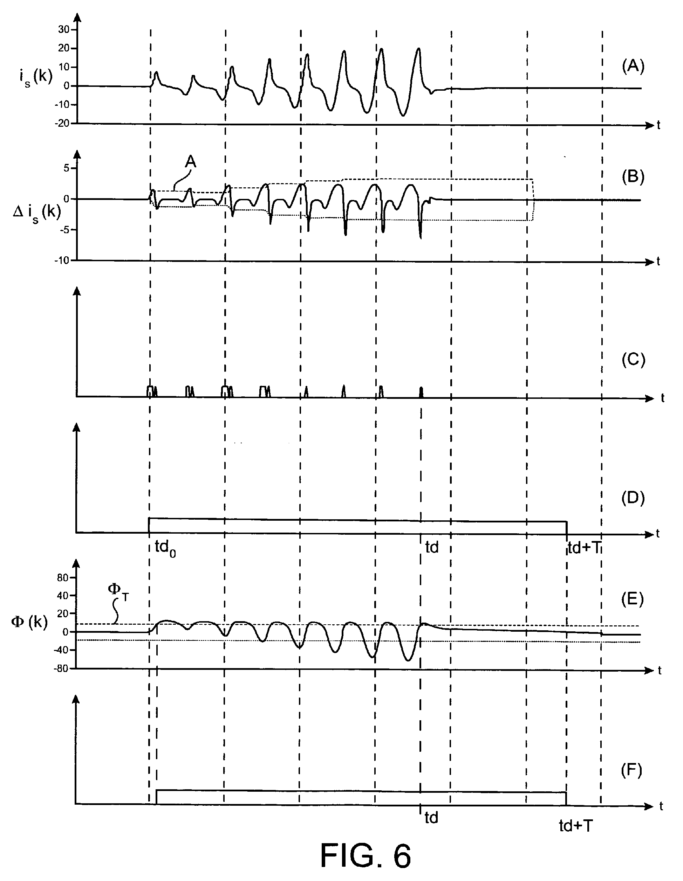

La Fig. 6 montre les chronogrammes de différentes variables illustrant le procédé de détection de saturation selon l'invention.

En (A), on a représenté l'évolution du courant secondaire $i_s(k)$ du transformateur au cours du temps. On reconnaît sur la courbe des déformations de la forme d'onde caractéristique d'une saturation similaires à celle vue en Fig. 5.

En (B), on a représenté l'évolution de l'accroissement $\Delta i_s(k)$ en fonction du temps ainsi que l'évolution de l'amplitude A.

En (C), on a représenté le résultat de la détection de défaut. On rappelle que si $\dfrac{\left|\Delta i_s(k)\right|}{A} > G$ un défaut de forme d'onde est détecté.

En (D), on a représenté la fenêtre temporelle d'intégration ; celle-ci est ouverte sur détection du premier défaut en $t_{d0}$ et est prolongée plusieurs fois jusqu'à $t_d + T$.

En (E), on a représenté le flux estimé par intégration selon l'expression (2). On remarque que, dès lors que le flux estimé franchit la valeur de seuil $\Phi_T$, le drapeau de saturation est levé.

En (F), on a représenté le drapeau logique de saturation. Le drapeau est remis à zéro après que la borne d'intégration $t_d + T$ ait été atteinte.

Dans un souci de simplification, on n'a pas pris en compte ici l'inhibition du signal de saturation.

La Fig. 7 illustre un exemple de système de protection d'un jeu de barres à l'aide de transformateurs de courant utilisant le procédé de détection de saturation selon l'invention. On a représenté par T un transformateur de courant à haute tension, les phases par a,b,c et le neutre par n. Des transformateurs de courant TCa, TCb, TCc, TCn sont disposés autour des barres de phase et du neutre. Des relais de protection Ra,Rb,Rc et Rn (non représentés) sont reliés aux bobinages secondaires des transformateurs TCa, TCb, TCc, TCn sont prévus pour déconnecter respectivement les phases a,b,c ainsi que le neutre, au moyen d'appareils de coupure. Les transformateurs de courant TCa, TCb, TCc sont par ailleurs montés en parallèle et connectés à une extrémité du transformateur de courant TCn, l'autre extrémité étant mise à la terre. Ainsi, les systèmes de protection sont montés en parallèle, le retour se faisant via le neutre. Si un défaut sur une barre (excès de courant) apparaît, la phase concernée et le neutre sont déconnectés.

Dans ce montage avec retour par le neutre, on peut montrer que le flux magnétique relatif à un transformateur de courant s'exprime sous la forme suivante similaire à celle de (2) :

$$\Phi_{meas} = -\left[\sum_k R\left(i_s(k) + i_s(k-1)\right) + R_{BN}\left(i_N(k) + i_N(k-1)\right)\right] Te/2 \qquad (11)$$

où $R_{BN}$ est la résistance de boucle du neutre et $i_N(k)$ est le courant parcourant le neutre au temps k.

La détection de la saturation se fait selon le même procédé que celui décrit en Fig.4 : sur apparition d'un défaut de forme d'onde de $i_s$, le flux est calculé par intégration dans une fenêtre temporelle, à partir de l'expression (11). Comme précédemment, la saturation du transformateur de courant est détectée si le flux mesuré est supérieur à la valeur de seuil $\Phi_T$. Si une saturation est détectée, la protection est inhibée.

## Revendications

1. Procédé de détection de saturation d'un transformateur de courant, **caractérisé en ce qu'**il comprend :

   - une étape de détection d'un défaut de la forme d'onde du courant secondaire du transformateur ;
   - une estimation du flux magnétique dans le secondaire du transformateur au moyen d'une intégration du courant secondaire pendant une fenêtre temporelle partant de la détection dudit défaut ;
   - une comparaison du flux magnétique ainsi estimé avec une valeur de seuil, la saturation du transformateur étant détectée sur franchissement de ladite valeur de seuil par ledit flux magnétique.

**2.** Procédé de détection selon la revendication 1, **caractérisé en ce que** ladite valeur de seuil est égale à 20% de la valeur du flux magnétique à la saturation du transformateur.

**3.** Procédé de détection de saturation selon la revendication 1 ou 2, **caractérisé en ce que**, si un second défaut de la forme d'onde du courant secondaire est détecté pendant ladite fenêtre temporelle, la borne supérieure de ladite fenêtre est réactualisée en fonction du temps d'apparition du second défaut.

**4.** Procédé de détection de saturation selon l'une des revendications précédentes, **caractérisé en ce qu'**une fin de saturation est détectée si un intervalle de temps de durée prédéterminée s'est écoulé sans qu'un défaut de forme d'onde du courant secondaire ait été détecté.

**5.** Procédé de détection de saturation selon l'une des revendications précédentes, **caractérisé en ce que** la détection d'un défaut de la forme d'onde du courant secondaire comprend le calcul d'une grandeur caractéristique de la dérivée du signal et une comparaison de ladite grandeur avec une fraction prédéterminée de l'amplitude du courant secondaire, un défaut étant détecté si ladite grandeur excède en valeur absolue ladite fraction.

**6.** Procédé de détection de saturation selon la revendication 5, **caractérisé en ce que** ladite fraction est de 16% pour un réseau électrique à 50 Hz et de 20% pour un réseau électrique à 60 Hz.

**7.** Procédé de détection de saturation selon l'une des revendications précédentes, **caractérisé en ce que** la détection de saturation est inhibée tant que le courant secondaire du transformateur n'a pas atteint un extremum.

**8.** Procédé de détection de saturation selon l'une des revendications précédentes, **caractérisé en ce que** la détection de saturation est inhibée pendant une durée prédéterminée après que le courant secondaire du transformateur soit devenu supérieur en valeur absolue à un seuil de bruit.

**9.** Programme d'ordinateur comprenant des moyens logiciels adaptés à mettre en oeuvre les étapes du procédé selon l'une des revendications précédentes, lorsqu'il est exécuté sur un ordinateur.

## Claims

**1.** A method of detecting saturation of a current transformer, said method being **characterized in that** it comprises:

• detecting a fault in the waveform of the secondary current of the transformer;
• estimating the magnetic flux in the secondary of the transformer by means of integration of the secondary current during a time window starting from detection of said fault; and
• comparing the magnetic flux thus estimated with a threshold value, saturation of the transformer being detected when said magnetic flux crosses said threshold value.

**2.** A method of detecting saturation according to claim 1, **characterized in that** said threshold value is equal to 20% of the value of the magnetic flux at saturation of the transformer.

**3.** A method of detecting saturation according to claim 1 or 2, **characterized in that**, if a second fault in the waveform of the secondary current is detected during said time window, the upper limit of said window is updated again as a function of the time of appearance of the second fault.

**4.** A method of detecting saturation according to any preceding claim, **characterized in that** an end of saturation is detected if a time interval of predetermined length has elapsed without a fault in the waveform of the secondary current being detected.

**5.** A method of detecting saturation according to any preceding claim, **characterized in that** detecting a fault in the waveform of the secondary current comprises computing a magnitude that is characteristic of the derivative of the signal and comparing said magnitude with a predetermined fraction of the amplitude of the secondary current, a fault being detected if said magnitude exceeds said fraction in absolute terms.

**6.** A method of detecting saturation according to claim 5, **characterized in that** said fraction is 16% for a 50 Hz electrical network and 20% for a 60 Hz electrical network.

7. A method of detecting saturation according to any preceding claim, **characterized in that** detecting saturation is disabled so long as the secondary current of the transformer does not reach an extremum.

8. A method of detecting saturation according to any preceding claim, **characterized in that** detecting saturation is disabled for a predetermined time after the secondary current of the transformer becomes higher in absolute terms than a noise threshold.

9. A computer program comprising software means adapted to carry out the steps of the method according to any preceding claim, when it is executed on a computer.


**Patentansprüche**

1. Verfahren zur Erfassung der Sättigung eines Stromtransformators, **dadurch gekennzeichnet, dass** es umfasst:

   - einen Schritt der Erfassung eines Fehlers der Wellenform des Sekundärstroms des Transformators;
   - eine Abschätzung des magnetischen Flusses im Sekundärkreis des Transformators mit Hilfe einer Integration des Sekundärstroms während eines Zeitfensters ausgehend von der Erfassung des Fehlers;
   - einen Vergleich des derart abgeschätzten magnetischen Flusses mit einem Schwellenwert, wobei die Sättigung des Transformators bei Überschreitung des Schwellenwerts durch den magnetischen Fluss festgestellt wird.

2. Verfahren zur Erfassung nach Anspruch 1, **dadurch gekennzeichnet, dass** der Schwellenwert gleich 20% des Werts des magnetischen Flusses bei der Sättigung des Transformators ist.

3. Verfahren zur Erfassung der Sättigung nach Anspruch 1 oder 2, **dadurch gekennzeichnet, dass** dann, wenn ein zweiter Fehler der Wellenform des Sekundärstroms während des Zeitfensters erfasst wird, die obere Grenze des Fensters als Funktion des Zeitpunkts des Auftretens des zweiten Fehlers wieder aktualisiert wird.

4. Verfahren zur Erfassung der Sättigung nach einem der vorhergehenden Ansprüche, **dadurch gekennzeichnet, dass** ein Ende der Sättigung erfasst wird, wenn ein Zeitintervall von vorbestimmter Dauer verstreicht, ohne dass ein Fehler der Wellenform des Sekundärstroms erfasst wird.

5. Verfahren zur Erfassung der Sättigung nach einem der vorhergehenden Ansprüche, **dadurch gekennzeichnet, dass** die Erfassung eines Fehlers der Wellenform des Sekundärstroms die Berechnung einer charakteristischen Größe der Ableitung des Signals umfasst sowie einen Vergleich der Größe mit einem vorbestimmten Bruchteil der Amplitude des Sekundärstroms, wobei ein Fehler erfasst wird, wenn die Größe in ihrem Absolutwert den Bruchteil übersteigt.

6. Verfahren zur Erfassung der Sättigung nach Anspruch 5, **dadurch gekennzeichnet, dass** der Bruchteil für ein elektrisches Netz mit 50 Hz 16 % und für ein elektrisches Netz mit 60 Hz 20% beträgt.

7. Verfahren zur Erfassung der Sättigung nach einem der vorhergehenden Ansprüche, **dadurch gekennzeichnet, dass** die Erfassung der Sättigung solange gehemmt wird, wie der Sekundärstrom des Transformators keinen Extremwert erreicht hat.

8. Verfahren zur Erfassung der Sättigung nach einem der vorhergehenden Ansprüche, **dadurch gekennzeichnet, dass** die Erfassung der Sättigung während einer vorbestimmten Dauer gehemmt wird, nachdem der Sekundärstrom des Transformators in seinem Absolutwert größer als eine Rauschschwelle geworden ist.

9. Computerprogramm, umfassend Softwaremittel, die dazu ausgelegt sind, die Schritte des Verfahrens nach einem der vorhergehenden Ansprüche auszuführen, wenn es auf einem Computer ausgeführt wird.

FIG. 1

FIG. 2

FIG. 3A

FIG. 3B

FIG. 4

FIG. 5

FIG. 7

FIG. 6

**EP 1 845 383 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2835319 A